# EUROPEAN PATENT APPLICATION

(11) **EP 2 600 425 A1**
(43) Date of publication of application: **05.06.2013**
(21) Application number: 11191161.6
(22) Date of filing: 29.11.2011
(51) Int. Cl.: H01L 31/048

(54) **Solar modules containing a single-layer polyolefin-based backsheet**

(71) Applicant: 3M Innovative Properties Company, Saint Paul, MN 55133-3427 (US)
(72) Inventor: Juergens, Michael, 41199 Mönchengladbach (DE); Schoeppel, Wolfgang, 41470 Neuss (DE); Stollwerck, Gunther, 47802 Krefeld (DE); Graichen, Andreas, 40721 Hilden (DE)
(74) Representative: Kurz, Arnd

(57) **Abstract**

A solar module (1) comprising in order of position from the front, i.e. the light-receiving side, to the back:
(a) a top part (40) comprising a top layer (11) and a solar cell layer (12) and
(b) a bottom part (41) comprising a single-layer backsheet (13) having a top surface (131) and opposite thereto a rear surface (111) that is exposed to the outside of the solar module (1) and wherein the single-layer backsheet (13) comprises a polyolefin layer (114) containing as its major component a cross-linked polymer selected from polyethene homo polymers, polypropene homopolymers, polyethene copolymers comprising repeating units derived from ethene and one or more α-olefinic hydrocarbons, polypropene copolymers comprising repeating units derived from propene and one or more α-olefinic hydrocarbons and combinations thereof.

Also provided are methods for making a solar module using the single-layer backsheets and methods for mounting a solar module on an aluminium containing support structure and support structures containing the solar module.

## Description

### Field

This disclosure relates to single-layered polyolefin-based backsheets and to methods for making solar modules by using the backsheets and to methods of mounting solar modules to support structures by using the backsheets.

### Background

The use of solar modules has rapidly increased due to a greater demand in renewable energies. The current solar cells can typically be classified into wafer-based solar modules (also referred to as crystalline solar cells or modules) and thin film solar modules. Wafer-based solar modules typically contain crystalline silicon, for example monocrystalline silicon (c-Si), poly- or multi-crystalline silicon (poly-Si or mc-Si). The wafers are generally about 180 and about 240 µm thick and are typically deposited on a support structure, the so-called solar cells. Several solar cells are typically electrically connected to each other and are arranged into a plane and form the so-called solar cell layer of a photovoltaic module. The solar cell layer is generally embedded in encapsulant material and protected by its top side, the light-receiving side by a cover sheet of light-transmitting material and on its rear side by a so-called backsheet. In general, a solar cell module comprises, in order of position from the front, i.e. the light-receiving side, to the rear side, i.e. the side opposite to the light-receiving side: a top layer, an encapsulated solar cell layer and a backing layer. The modules usually contain perimeter frames made of aluminium to further protect the brittle modules and for mounting the solar modules onto a surface or structure to which they are installed to generate electricity, for example rails or roofs.

The solar industry is very competitive due to the steeply increased demand on renewable energies. Therefore, the solar industry is under pressure to reduce costs. Therefore, solutions are desired which are efficient but more cost-effective.

### Summary

Therefore in one aspect there is provided a solar module (1) comprising in order of position from the front, i.e. the light-receiving side, to the back:
(a) a top part (40) comprising a top layer (11) and a solar cell layer (12) and
(b) a bottom part (41) comprising a backsheet (13) containing a polyolefin sheet (114) having a top surface (131) contacting at least partially the solar cell layer and opposite thereto a rear surface (111) that is at least partially exposed to the outside of the solar module (1) and which contains as its major component a cross-linked polymer selected from polyethene homo polymers, polypropene homopolymers, polyethene copolymers comprising repeating units derived from ethene and one or more α-olefinic hydrocarbons, polypropene copolymers comprising repeating units derived from propene and one or more α-olefinic hydrocarbons and combinations thereof.

In a further aspect there is provided a method for making a solar module (1) comprising
i) providing a top layer (11) and a solar cell layer (12) with semiconductors on an aluminium containing carrier (124) and a back sheet (13),
ii) laminating the top surface (131) of the backsheet (13) to rear surface of the aluminium containing carrier material (124) by subjecting at least the top surface (131) of the back sheet (13) to a heat treatment.

In another aspect there is provided a method for mounting a solar module (1) on an aluminium containing support structure comprising
i) providing a solar module (1);
ii) laminating the backsheet onto the support structure.

In yet another aspect there is provided an aluminium containing support structure (2) for holding a solar module comprising a solar module (1) laminated to at least a part of the support structure (2) by a direct bond between the backing layer (13) and the support structure.

### Brief Description of the Figures

Figure 1 is a schematic cross-sectional view of a photovoltaic module.
Figure 2 A is a schematic cross-sectional view of a photovoltaic module mounted on a support frame by means of adhesives according to the prior art.
Figure 2 B is a schematic representation of a solar module mounted on a frame and fixed on a pole.
Figure 2C is a schematic representation of a solar module mounted on a frame and fixed on the roof of a building.
Figures 3 A and 3B are schematic cross-sectional representations of a solar module comprising a backsheet according to the present disclosure showing solar modules with a fully encapsulated solar cell layer (figure 3A) and a partially encapsulated layer (figure 3B).
Figure 4 is a schematic cross-sectional representation of a solar module according to the present disclosure containing a backsheet that can be wrapped around the edges of the top part of the solar module
Figure 5 is a schematic cross-sectional view of a solar module containing a single-layer backsheet according to the present disclosure mounted on a backrail according to the present disclosure.
Figure 6 is a schematic cross-sectional view of a solar module containing a single-layer backsheet wrapped around the edges of the top part of the solar module and mounted on a frame according to the present disclosure.

### Detailed Description

Before any embodiments of this disclosure are explained in detail, it is to be understood that the disclosure is not limited in its application to the details of construction and the arrangement of components set forth in the following description. The invention is capable of other embodiments and of being practiced or of being carried out in various ways. Also, it is to be understood that the phraseology and terminology used herein is for the purpose of description and should not be regarded as limiting.

As used herein, the terms "comprising," "including," "containing," "characterized by," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus and including equivalents. Further, unless expressly stated to the contrary, "or" refers to an inclusive or and not to an exclusive or.

As used herein, the term "consisting of" is meant to be limiting and include only the specified materials or steps and their equivalents.

The use of "a" or "an" is meant to encompass "one or more".

Any numerical range recited herein is intended to include and to specifically disclose the end points specified and also all integers and fractions within that range. For example, a range of from 1% to 50% is intended to be an abbreviation and to expressly disclose the values 1% and 50% and also the values between 1% and 50%, such as, for example, 2%, 40%, 10%, 30%, 1.5%, 3.9 % and so forth.

The term "copolymer" is used to refer to polymers containing two or more monomers.

### Solar modules:

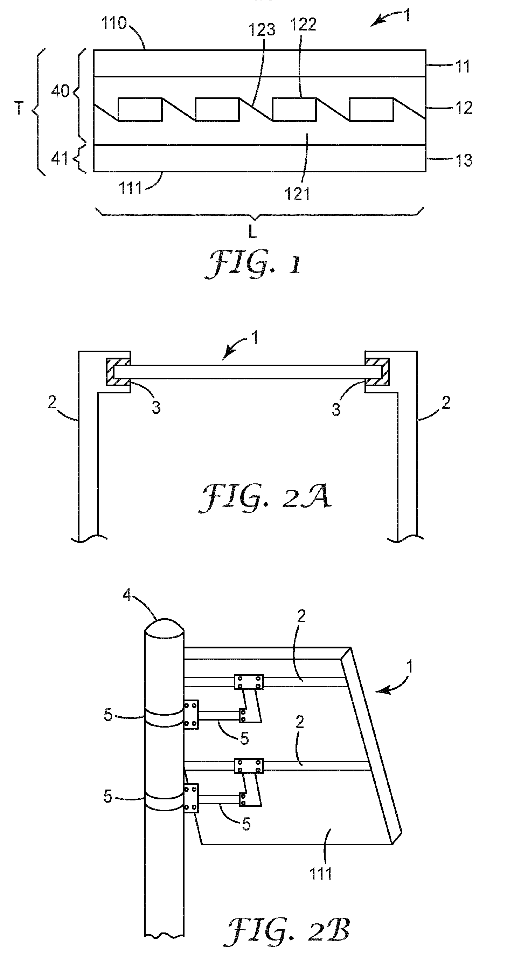

A typical solar module is shown in figure 1, to which is now referred: a solar module (1) typically comprises a front side (110) and a rear side (111). The front side (110) is the external light-receiving side and is a major external side of the solar module. The rear side (111) is another major external side of the solar module and is opposite to the front side (110). Major side mean the side is the largest side of the module. The solar module contains along its thickness (T) (or edge), i.e., in order of position from the front side (110) to the rear side (111)): a top layer (11), a solar cell layer (12) and a backing layer (13). The top layer (11) and the solar layer (12), including optional layers between them, make up the top part (40) of the solar module (1). The bottom part (41) comprises the backing layer (13).

The top layer (11) serves as the outermost layer of the module at the light-receiving side. The outermost layer may be formed of any suitable transparent sheets or films. Suitable sheets may be glass or plastic sheets, such as polycarbonates, acrylic polymers (i.e., thermoplastic polymers or copolymers of acrylic acid, methacrylic acid, esters of these acids, or acrylonitrile), polyacrylates, cyclic polyolefins (e.g., ethylene norbornene polymers), polystyrenes (preferably metallocene-catalyzed polystyrenes), polyamides, polyesters, fluoropolymers, or combinations of two or more thereof. Typically, the outmost layers are made of glass. The term "glass" includes not only window glass, plate glass, silicate glass, sheet glass, low iron glass, tempered glass, tempered CeO-free glass, and float glass, but also colored glass, specialty glass (such as those types of glass containing ingredients to control solar heating), coated glass (such as those sputtered with metals (e.g., silver or indium tin oxide) for solar control purposes), E-glass, Toroglass, SOLEX glass (PPG Industries, Pittsburgh, Pa, USA.) and STARPHIRE glass (PPG Industries). It is understood, however, that the type of glass to be selected for a particular module depends on the intended use. The top layer(s) may be a single layer or a multi-layer construction.

The solar cell layer (12) contains at least one solar cell (122) and at least one polymeric material (121) encapsulating fully or partially the at least one solar cell (122). Typically, the electricity generated by a single solar cell is too low and solar modules typically contain a series of a plurality of solar cells. The solar cells are electrically interconnected (typically in series). Generally they arranged in a flat plane. Therefore, the solar cell layer (12) also contains electrical wirings (123) connecting the solar cells and connecting them to the outside of the module. The wiring includes cross ribbons and bus bars which collect the electricity generated by the solar cells and transport them to an electrical contact at the outside of the solar module.

The solar cells contain the semiconductors which generate electricity from the incident light. Various types of semiconductors may be used in solar cells. Examples include monocrystalline silicon (c-Si solar sells), polycrystalline silicon (p-Si or mc-Si solar cells) and amorphous silicon (a-Si solar cells). Other solar cells include GaAS solar cells, CdTe solar cells, CIS or CIGS solar cells which contain copper-indium-selenide or sulfide or copper-indium-gallium selenide or sulfide. The latter are predominantly used on so called thin-film solar modules, which are thinner than solar modules using crystalline silicons. The semiconductors may be deposited on a carrier, typically an aluminum containing material, like an aluminum sheet or a material containing an aluminum paste or coating. A conductive grid is placed on the light-receiving surface of the solar cell. The grid typically contains a plurality of parallel lines. These lines are typically coated or screen printed onto the semiconductors. The lines generally contain a conductive ink. The lines feed into conductive strips, also called "fingers" , which collect the charge and transport the current generated by the cells away by collecting wires. Preferred solar cells are wafer-based solar cells (e.g., c-Si or mc-Si based solar cells), typically deposited on a carrier, like for example an aluminium carrier.

The interconnected solar cells in photovoltaic modules are generally at least partially embedded in one or more encapsulants (121). Therefore, the solar cell layer (12) also contains one or more encapsulant. The solar cell layer (12) may be completely encapsulated, which means the light-receiving side of the solar cells and the rear side (i.e. the side opposite to the light-receiving side), or more specifically the carrier onto which the semiconductors have been deposited, is covered by one or more encapsulants (121). The encapsulants (121) may comprise any suitable polymeric material. Such materials melt or flow under the lamination conditions (i.e. the temperature and pressure applied to laminate the encapsulant material (121) onto the solar cells and their support) onto which they are deposited and undergo curing, i.e. cross-linking. Some specific examples of such polymeric materials include acid copolymers (copolymers of an olefin and an unsaturated carboxylic acid or acid anhydride), poly(ethylene vinyl acetates), poly(vinyl acetals), polyurethanes, poly(vinyl chlorides), copolymers of an α-olefin and an α,β-ethylenically unsaturated carboxylic acid ester (e.g., ethylene methyl acrylate copolymer and ethylene butyl acrylate copolymer), silicone elastomers, epoxy resins, and combinations of two or more thereof. Preferably, the encapsulant (121) comprises poly(ethylene vinyl acetates) (EVA), i.e. a copolymer comprising repeating units derived from ethene and vinyl acetate. Thus, the solar cell layer (12) has a light-receiving side (the front side or the side facing the top layer (11)) and a rear side opposite thereto, facing the backing layer (13). A fully encapsulated solar cell layer (12) is covered by its front and rear sides by encapsulant (121). In partially encapsulated solar cell layers (12) only one of these sides, typically the front side of the solar cell layer is covered by an encapsulant (121).

Solar modules contain at their rear side a backing layer. The backing layer protects the solar module from environmental deterioration and provides electrical insulation. Typical commercial materials for backing layers, also referred to as backsheets, are multi-layered articles containing an electrically insulating polyester layer and/or a weather-resistance fluoropolymer layer. They may additionally contain a top layer, like an EVA layer, for providing good adhesion to the encapsulant. Other commercial materials employ polyamides or other polymers. Solar modules (1) according to the present disclosure contain a polyolefin backsheet (13) as described in greater detail below.

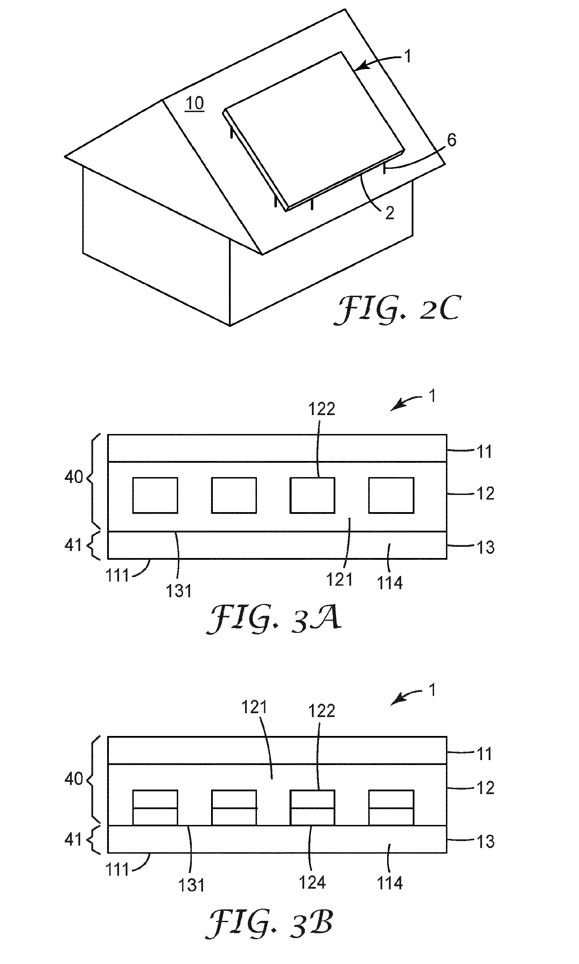

Photovoltaic modules are typically mounted onto frames and are then installed on structures, for example on poles or rails of solar power stations or on roofs of buildings. The frames typically have an area designed for receiving the edges of the solar module as shown in figure 2A to which will now be referred. The frames (2) have a part (21) for receiving the solar module (1) which, for example, may be a recess or a bracket. Typically, the area (21) for receiving the solar module is somewhat deeper and wider than the edges of the solar module. The solar modules are typically held in the receiving area by use of adhesives like liquid adhesives or adhesive tapes (3). Modules mounted on such frames are then installed on other structures as represented in figures 2B and 2C. In figure 2B the solar module (1) mounted on a support (2) by its rear surface (111) and is attached to a pole (4) by mechanical fastening means and hinges (5). In figure 2C the frame (2) onto which the solar module (1) had been mounted has been attached by carriers (6) to the roof (10) of a building.

The inventors have realised that single-layered polyolefin-based backsheets (13) may be conveniently attached (laminated) to aluminium surfaces using a heat treatment. By laminating such backsheets to the rear surface of the aluminium containing carriers of the semiconductors in solar cells, the backsheets can be used to seal the rear side of the solar cells. Encapsulant material can be saved by using the backsheets according to the present disclosure by which costs can be saved and the assembly procedure of solar modules can be simplified. Alternatively, or in addition, the solar modules may be attached to aluminium containing support structures by laminating the backsheet, for example by their rear side, to the support structure which saves costs on adhesive materials and may also simplify the assembly. The single-layer polyolefin material may be sufficient to provide the mechanical stability, weathering (yellowing) resistance and/or electrical insulation required for backsheets in solar modules. Surprisingly, backsheets disclosed herein can be more resistant to exposure to humid heat than multi-layered materials containing no polyolefin-based layers as described herein.

The backsheets provided herein are materials comprising a single polyolefin sheet (114) and will now be described in greater detail by referring to figures 3 to 6 for illustration. Figures 3A and 3B show a schematic cross-sectional representation of solar modules according to the present disclosure. The solar modules (1) contain (from the top (i.e. the light receiving side along a direction parallel to the thickness (T), (or the edge of the solar module) a top part (40) comprising a top layer (11) and a solar cell layer (12). Attached to the solar cell layer (12) is the bottom part (41) comprising or consisting of the backsheet (13). The backsheet (13) according to the present disclosure comprises a polyolefin-based sheet (114). The polyolefin-based sheet (114) contains a top surface (131) directed to the solar cell layer (12) and at least partially contacting it and a rear surface (111) opposite to the top layer (131) which forms, at least partially, the external side of the solar module (1), more specifically, the external rear side of the solar module (opposite to the light-receiving side). The light receiving side (top surface) and the opposite side (rear surface) are the two major sides of the solar module.

The backsheet (13) may be laminated to the encapsulant (121) of the solar cell layer (12), typically in case of fully encapsulated solar cells (122) as shown in figure 3A. By laminating the backsheet to the solar cell layer the top surface of the polyolefin sheet (114) contacts the solar cell layer, either the encapsulant or the carrier material of the solar cells or both. This contact may be a direct contact. The contact may be made by the entire top surface of the polyolefin sheet (114) or at least by a part of the top surface of the polyolefin sheet (114).

Alternatively, the backsheet (13) may be attached to the rear surface of the carrier material (124) of the semiconductors as shown in figure 3B. In this case the solar cell layer (12) contains only partially encapsulated solar cells. The backsheet (13) is laminated (directly bonded) to the rear surface of the carrier material (124).

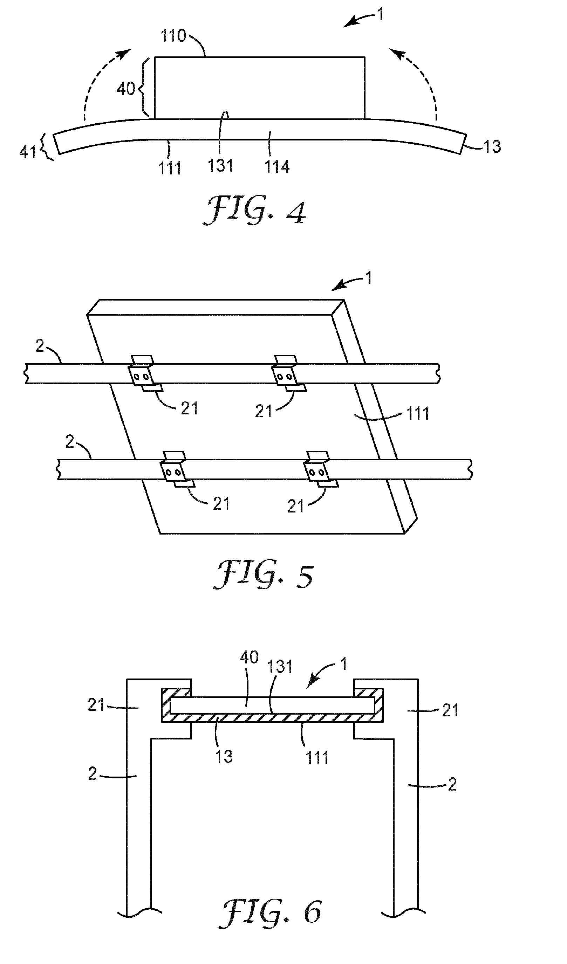

The solar modules (1) according to the present disclosure may also be attached (laminated) to an aluminium containing support structure (2). The solar modules (1) according to the present disclosure may be attached by the rear surface (111) of the backsheet (13) to aluminium support structures (2), like frames or backrails. The backsheet may have the same length (L) and/or width (W) as the top part (40) of the solar module (1) or it may have a smaller length and/or width than the top part of the solar module. In one embodiment, the backsheet is bonded by at least a section of its rear side to an aluminium containing support structure (2), for example a backrail or a component of a backrail (21) as shown in figure 5.

Alternatively, or in addition, the backsheet (1) may be dimensioned such that it can be wrapped around at least one or more than one or all edges of the top part (40) of the solar module (1). This means the backsheet (13) is of greater length (L) and/or width (W) than the top part (40) of the solar module (1). Such an embodiment is shown in figure 4. Figure 6 shows a solar module (1) according to the present disclosure having a top part (40) and a back part (41) containing a back sheet (13) wrapped around the edges of the top part (40) of the solar module (1) and mounted on an aluminium containing frame (2). The frame is shaped (21) to receive the solar module (1) and the solar module is bonded to the frame by a bond between the backsheet (13) and the aluminium surface of the frame (2). The bond is created by a heat treatment as described below. The top part (40) may contain a partially or a fully encapsulated solar cell layer (12) and the solar cell layer (12) may be connected to the backsheet (13) by a direct bond to the encapsulant material (121) (as represented in figure 3A) or a direct bond to the rear side of the carrier material (124) (as represented in figure 3B).

The backsheet (13) according to the present disclosure provides electrical insulation. Typically, the backsheet has a dielectric breakdown voltage of at least 10 kV or at least 20 kV. The break down voltage can be determined according to ASTM D 149.

The backsheets (13) may also provide mechanical protection of the solar module. Typically, the backsheets have an elongation at break of at least 50% and a tensile strength of at least 15 MPa. The mechanical properties can be determined according to ASTM D 882.

The backsheet (13) typically has a total thickness of from about 0.22 mm (or 0.250 mm) to about 0.80 mm or from about 0.35 mm to about 0.70 mm, or from about 0.40 mm to about 0.65 mm. A greater thickness is not harmful but adds to the costs of the material.

The backsheets (13) may be surface treated. The top and/or rear surface of the backsheets (13) may be surface treated. Surface treatment may be carried out to improve the compatibility or adhesion to another surface or to provide a functional or decorative pattern or structure. For example, the backsheets (13) may have smooth or rough surfaces on one or both of its external sides which typically coincide with the top and rear surfaces (130, 111) of the polyolefin sheet (114) because the backsheet typically is a single-sheet article. Rough surfaces may facilitate deaeration during the lamination process when the backsheet is included in a solar cell module. Rough surfaces can be created by mechanical embossing or by melt fracture during extrusion of the sheets followed by quenching so that surface roughness is retained during handling.

A typical example for surface treatment to improve adhesion to other substrates, such as for example, external components like junction boxes, or mounting materials involves a plasma treatment, like a corona treatment. Corona treatments may be carried out for example under air or nitrogen atmosphere or other suitable atmospheres. The backsheets are preferably subjected to a corona treatment because this may also increase the adhesion of the polyolefin layer to aluminium. Corona treatment (plasma treatment) is a surface modification technique that uses a plasma to impart changes in the properties of a surface. The corona plasma is generated by the application of high voltage to sharp electrode tips which forms plasma at the ends of the sharp tips. A linear array of electrodes is often used to create a curtain of corona plasma. The material may be passed through the corona plasma curtain in order to change the surface energy of the material.

### Polyolefin sheet:

The backsheets provided contain a single polyolefin sheet (114). The polyolefin layer (114) according to the present disclosure contains cross-linked polyethene (PE) or polypropene (PP) polymers. The PE and/or PP polymers are preferably present in an amount of greater than 50% by weight or even greater than 75% by weight or even greater than 90% by weight. The weight percentages are based on the weight of the backsheet (13).

Polyethene polymers (PE's) include homo- and copolymers of ethene, i.e. polymers comprising repeating units derived from ethene.

The PE polymers typically contain more than 50% by mole, preferably more than 60% by mole or more than 80% by mole and more preferably at least 95% by mole or more than 99% by mole or 100% by mole of units derived from ethene.

Suitable comonomers include alkenes, in particular α-olefins such as but not limited to propene, 1-butene, 1-hexene, 1-octene and combinations thereof. Alkenes as used herein above and below include hydrocarbons with one carbon-carbon double bond and hydrocarbons with two carbon-carbon double bonds. The α-olefins may be branched or cyclic or linear. Further examples include 4-methyl-1-pentene, 1-decene, 1-dodecene, 1-tetracene, 1-hexadecene, 1-octadecene. Suitable α-olefins include hydrocarbons of the general formula (CₙH₂ₙ) with a terminal carbon-carbon double bond and having up to 20 carbon atoms.

Polypropene polymers (PP's) include homo- and copolymers of propene, i.e. polymers comprising repeating units derived from propene.

The PP polymers typically contain more than 50% by mole, preferably more than 60% by mole or more than 80% by mole and more preferably at least 95% by mole or more than 99% by mole or 100% by mole of units derived from propene.

Suitable comonomers include alkenes, in particular α-olefins such as but not limited to ethene, 1-butene, 1-hexene, 1-octene and combinations thereof. Alkenes as used herein above and below include hydrocarbons with one carbon-carbon double bond and hydrocarbons with two carbon-carbon double bonds. The α-olefins may be branched or cyclic or linear. Further examples include 4-methyl-1-pentene, 1-decene, 1-dodecene, 1-tetracene, 1-hexadecene, 1-octadecene. Suitable α-olefins include in general hydrocarbons of the general formula (CₙH₂ₙ) with a terminal carbon-carbon double bond and having up to 20 carbon atoms.

In one embodiment the PP polymer is selected from PP homo- or copolymers comprising more than 99% by mole of repeating units derived from propene, PP copolymers comprising at least 50% preferably at least 60%, more preferably at least 80 % and most preferably at least 95% by mole of repeating units derived from propene and one or more comonomers selected from alkenes, in particular α-olefins.

The PE and PP polymers used in the preparation of the backsheets may have a melting point (before cross-linking) of at least 100°C. The PE and PP polymers may be linear or branched. The PE and PP polymers may be blockpolymers, core-shell polymers or blends of polymers of different molecular weight distributions, or different chemical compositions or different polymer architecture. The polymers may also be grafted polymers.

Examples of suitable PE polymers include but are not limited to UHMWPE, HDPE, MDPE, LDPE, LLDPE, VLDPE. UHMWPE (ultra high molecular weight polyethene) is a polyethylene polymer with a molecular weight greater than 1 x 10⁶ g/mole, usually between 3.1 and 5.67 million g/moles. It typically has a density of 0.930-0.935 g/cm³. HDPE (high density polyethene) is a polyethylene polymer having a density of greater or equal to 0.941 g/cm³. MDPE (medium density polyethene) is a polyethylene polymer having a density range of 0.926-0.940 g/cm³. LLDPE (linear low density polyethene) is a polyethylene polymer having a density range of 0.915-0.925 g/cm³. LDPE (low density polyethene) is a polyethene polymer having a density range of 0.910-0.940 g/cm³. VLDPE (very low density polyethene) is a polyethene polymer having a density range of 0.880-0.915 g/cm³. It has been found that not only polymers of the same architecture (e.g. only branched or only linear polymers) may be used but also blends of polymers of different structures, like, linear and non-linear polymers, may be used in the backsheets provided herein.

The PE or PP polymers of the polyolefin sheet (114) are in cross-linked form in the assembled backsheet (and in the solar module) but may be used in non-cross-linked form in the preparation of the backsheet and cross-linked afterwards. The cross-linking may be carried out chemically or physically, the latter being preferred. In chemical cross-linking the composition contains a cross-linker as described below. The cross-linker may be activated thermally, by chemical reaction or by irradiation, typically UV irradiation. In physical cross-linking the cross-linking is achieved by irradiating the polymers with γ- or e-beam irradiation. Preferably, the cross-linking is carried out by e-beam irradiation. The polyolefin sheet (114) may be cross-linked by the same or different cross-linking methods or cross-linkers and may be subjected by sequential cross-linking. A combination of physical and chemical crosslinking may also be used. Preferably the polyolefin-based sheet is cross-linked by e-beam treatment. By cross-linking the polymers form a network. This means the polymers lose their melting point, i.e. the cross-linked material does not melt at a temperature at which the polymers making up the network would melt. It either melts at a higher temperature or it does not melt at all but decomposes at a temperature greater than the melting point of the polymers used to make the network.

In a preferred embodiment the polyolefin-based sheets (114) are not cross-linked by chemical cross-linking agents or do not contain chemical cross-linking agents. The polymers of the polyolefin sheet (114) according to this disclosure are preferably cross-linked by physical treatment, like, but not limited to, e-beam treatment.

In one embodiment the polyolefin sheet (114) contains as a major component a polyethene polymer containing more than 75% by mole or more than 85% by mole or more than 95% by mole of units derived from ethene. The sheets are cross-linked, for example by physical cross-linking, like but not limited to e-beam irradiation. The dosages and/or acceleration voltages used can be optimized according to the desired performance and properties of the polyolefin-based sheet. Typical total dosages that may be applied by single or multiple treatments may be between more than 10 Mrad or more than 16 Mrad, for example 20 Mrad, 25 Mrad, 30 Mrad, 39 Mrad, 40, Mrad, 43 Mrad, 47 Mrad, 50 Mrad, 56 Mrad. Alternatively, the dosage may be less than 200 Mrad, e.g. 195 Mrad, 175, Mrad, 146 Mrad, 135 Mrad, 124 Mrad, 112 Mrad, 108 Mrad, 92 Mrad or 85 Mrad. Alternatively, the dosage may be less than 80 Mrad, e.g, 73 Mrad, 62 Mrad or 51 Mrad. Typical acceleration voltages may be between 50 and 500 kV, e.g. 70kV, 80kV, 90kV, 100kV, 110kV, 120kV, 130kV, 140kV, 150kV, 160kV, 170kV, 180kV, 190kV, 200kV, 210kV, 220kV, 230kV, 240kV, 250kV, 260kV, 270kV, 280kV, 290kV, 300kV, 310kV, 320kV, 330kV, 340kV, 350kV, 360kV, 370kV, 380kV, 390kV, 400kV, 410kV, 420kV, 430kV, 440kV, 450kV, 460kV, 470kV, 480kV, 490 kV.

The polyolefin sheet may contain additives to enhance specific physical or mechanical properties of the backsheet (13). For example, the polyolefin-based sheet (114) may contain additives such as for example but not limited to cross-linker, anti-oxidants, UV-absorber, flame retardants, anti-dripping agents, pigments, dyes, reflective materials, carbon particles and combinations thereof. The types and amounts of additives depend on the construction of the backing layer (13) in particular its dimensions. Such additives will be described in greater detail below.

### Cross-Linker:

The polyolefin-based materials are cross-linked. Preferably the sheets are cross-linked by physical irradiation, more preferably by e-beam treatment. Less preferred are cross-linking by chemical cross-linking agents. Chemical cross-linking agents may be activated thermally or by irradiation. Typical chemical cross-linking agents include vinyl-silanes, such as but not limited to vinyl-tri-ethoxy or vinyl trimethoxy silane. They may be blended or copolymerised with the PE or PP polymers. Other types of chemical cross-linkers include radical cross-linker which decompose to generate radicals. These radicals then lead to a cross-linking reaction. Examples include but are not limited to peroxides and azo-compounds. Examples for cross-linkers activated by irradiation include but are not limited to benzophenones. Typically, the cross-linkers are dispersed in the PE or PP polymers or blended with them.

### Anti-oxidants:

Anti-oxidants can be chosen from a wide range of known anti-oxidants that are compatible with polyolefins. Examples include but are not limited to phenolic or phosphitic anti-oxidants, such as alkylated monophenols, alkylthiomethylphenols, hydroquinones, alkylated hydroquinones, tocopherols, hydroxylated thiodiphenyl ethers, alkylidenebisphenols, acylaminophenols. Other examples include but are not limited to O-, N- and S-benzyl compounds, hydroxybenzylated malonates, aromatic hydroxybenzyl compounds, triazine compounds, aminic antioxidants, aryl amines, diaryl amines, polyaryl amines, oxamides, metal deactivators, phosphites, phosphonites, benzylphosphonates, ascorbic acid (vitamin C), compounds which destroy peroxide, hydroxylamines, nitrones, benzofuranones, indolinones, and the like and mixtures thereof. More preferably, the antioxidant is a member of the class of bis-phenolic antioxidants. Suitable specific bis-phenolic antioxidants include 2,2'-ethylidenebis(4,6-di-t-butylphenol); 4,4'-butylidenebis(2-t-butyl-5-methylphenol); 2,2'-isobutylidenebis(6-t-butyl-4-methylphenol); and 2,2'-methylenebis(6-t-butyl-4-methylphenol). Some commercially available bis-phenolic antioxidants include ANOX 29, LOWINOX 22M46, LOWINOX 44B25, and LOWINOX 22IB46.

### UV-absorbers:

UV-absorbers are substances that absorb UV light and thus prevent the formation of free radicals.

Typical examples of UV absorbers include aliphatic cyclic amines or aromatic amines and benzophenones. UV-absorbers include but are not limited to triazines, benzotriazoles, hydroxybenzophenones, hydroxyphenyltriazines, esters of benzoic acids, and mixtures of two or more thereof. Further examples include cyclic aliphatic amines. Examples include secondary, tertiary, acetylated, N-hydrocarbyloxy substituted, hydroxy substituted N-hydrocarbyloxy substituted, or other substituted cyclic amines which are further characterized by a degree of steric hindrance, generally as a result of substitution of an aliphatic group or groups on the carbon atoms adjacent to the amine function. Such compounds are commonly referred to as HALS (hindered amine light stabilizers). HALS also have anti-oxidative properties and can be used in addition or instead of anti-oxidants described above. Specific examples of HALS include, but are not limited to, 4-hydroxy-2,2,6,6-tetramethylpiperidine, 1-allyl-4-hydroxy-2,2,6,6-tetramethylpiperidine, 1-benzyl-4-hydroxy -2,2,6,6-tetramethylpiperidine, bis(2,2,6,6-tetramethyl-4-piperidyl) sebacate, bis(2,2,6,6-tetramethyl-4-piperidyl) succinate, bis(1,2,2,6,6-pentamethyl-4-piperidyl) sebacate, bis(1-octyloxy-2,2,6,6-tetramethyl-4-piperidyl) sebacate, bis(1,2,2,6,6-pentamethyl-4-piperidyl)n -butyl-3,5-di-tert-butyl-4-hydroxybenzylmalonate, the condensate of 1-(2-hydroxyethyl)-2,2,6,6-tetramethyl-4-hydroxypiperidine and succinic acid, linear or cyclic condensates of N,N'-bis(2,2,6,6-tetramethyl-4-piperidyl)hexamethylenediamine and 4-tert-octylamino-2,6-dichloro -1,3,5-triazine, tris(2,2,6,6-tetramethyl-4-piperidyl) nitrilotriacetate, tetrakis(2,2,6,6-tetramethyl-4-piperidyl)-1,2,3,4-butane-tetracarboxylate, 1,1'-(1,2-ethanediyl)-bis(3,3,5,5-tetramethylpiperazinone), 4-benzoyl-2,2,6,6-tetramethylpiperidine, 4-stearyloxy-2,2,6,6-tetramethylpiperidine, bis(1,2,2,6,6-pentamethylpiperidyl)-2-n-butyl-2-(2-hydroxy-3,5-di-tert -butylbenzyl)malonate, 3-n-octyl-7,7,9,9-tetramethyl-1,3,8-triazaspiro[4,5]decan-2,4-dione, bis(1-octyloxy-2,2,6,6-tetramethylpiperidyl) sebacate, bis(1-octyloxy-2,2,6,6-tetramethyl -piperidyl) succinate, linear or cyclic condensates of N,N'-bis-(2,2,6,6-tetramethyl-4-piperidyl) -hexamethylenediamine and 4-morpholino-2,6-dichloro-1,3,5-triazine, the condensate of 2-chloro-4,6-bis(4-n-butylamino-2,2,6,6-tetramethylpiperidyl )-1,3,5-triazine and 1,2-bis(3-amino -propylamino)ethane, the condensate of 2-chloro-4,6-di-(4-n-butylamino-1,2,2,6,6-pentamethylpiperidyl)-1,3,5-triazine and 1,2-bis-(3-aminopropylamino)ethane, 8-acetyl-3-dodecyl-7,7,9,9-tetramethyl-1,3,8-triazaspiro[4,5]decane-2,4-dione, 3-dodecyl-1-(2,2,6,6-tetramethyl-4-piperidyl)pyrrolidin-2,5-dione, 3-dodecyl-1-(1,2,2,6,6-pentamethyl-4-piperidyl)pyrrolidine-2,5-dione, a mixture of 4-hexadecyloxy-and 4-stearyloxy-2,2,6,6-tetramethylpiperidine, a condensation product of N,N'-bis(2,2,6,6-tetramethyl-4-piperidyl)hexamethylenediamine and 4-cyclohexylamino-2,6-dichloro-1,3,5-triazine, a condensation product of 1,2-bis(3-aminopropylamino)ethane and 2,4,6-trichloro-1,3,5-triazine as well as 4-butylamino-2,2,6,6-tetramethylpiperidine (CAS Reg. No. [136504-96-6]); N -(2,2,6,6-tetramethyl-4-piperidyl)-n-dodecylsuccinimid, N-(1,2,2,6,6-pentamethyl-4-piperidyl)-n -dodecylsuccinimid, 2-undecyl-7,7,9,9-tetramethyl-1-oxa-3,8-diaza-4-oxo-spiro[4,5]decane, a reaction product of 7,7,9,9-tetramethyl- 2-cycloundecyl-1-oxa-3,8-diaza-4-oxospiro [4,5]decane and epichlorohydrin, 1,1-bis(1,2,2,6,6-pentamethyl-4-piperidyloxycarbonyl)-2-(4-methoxyphenyl)ethene, N,N'-bis-formyl-N,N'-bis(2,2,6,6-tetramethyl-4- piperidyl)hexamethylenediamine, diester of 4-methoxy-methylene-malonic acid with 1,2,2,6,6-pentamethyl-4-hydroxypiperidine, poly[methylpropyl-3-oxy-4-(2,2,6,6-tetramethyl-4-piperidyl)]siloxane, reaction product of maleic acid anhydride-[alpha]-olefin-copolymer with 2,2,6,6-tetramethyl4-aminopiperidine or 1,2,2,6,6-pentamethyl-4-aminopiperidine.

Examples for sterically hindered amines substituted on the N-atom by a hydroxy-substituted alkoxy group, include but are not limited to 1-(2-hydroxy-2-methylpropoxy)-4-octadecanoyloxy-2,2,6,6-tetramethylpiperidine, 1-(2-hydroxy-2-methylpropoxy)-4-hexadecanoyloxy-2,2,6,6-tetramethylpiperidine, the reaction product of 1-oxyl-4-hydroxy-2,2,6,6-tetramethylpiperidine with a carbon radical from t-amylalcohol, 1-(2-hydroxy-2-methylpropoxy)-4-hydroxy-2,2,6,6-tetramethylpiperidine, 1-(2-hydroxy-2-methylpropoxy)-4-oxo-2,2,6,6-tetramethylpiperidine, bis(1-(2-hydroxy-2-methylpropoxy)-2,2,6,6-tetramethylpiperidin-4-yl) sebacate, bis(1-(2-hydroxy-2-methylpropoxy)-2,2,6,6-tetramethylpiperidin4-yl) bis(1-(2-hydroxy-2-methylpropoxy)-2,2,6,6-tetramethylpiperidin-4-yl) succinate, bis(1-(2-hydroxy-2-methylpropoxy)-2,2,6,6-tetramethylpiperidin-4-yl) glutarate and 2,4-bis{N-[1-(2-hydroxy-2-methylpropoxy)-2,2,6,6-tetramethylpiperidin-4-yl]-N-butylamino}-6-(2-hydroxyethyl-amino)-s-triazine.

Oxamides, include, for example, 4,4'-dioctyloxyoxanilide, 2,2'-diethoxyoxanilide, 2,2'-dioctyloxy-5,5'-di-tert-butoxanilide, 2,2'-didodecyloxy-5,5'-di-tert-butoxanilide, 2-ethoxy-2'-ethyloxanilide, N,N'-bis(3-dimethylaminopropyl)oxamide, 2-ethoxy-5-tert-butyl-2'-ethoxanilide and its mixture with 2-ethoxy-2'-ethyl-5,4'-di-tert-butoxanilide, mixtures of o- and p-methoxy-disubstituted oxanilides and mixtures of o- and p-ethoxy-disubstituted oxanilides.

### Flame retardants:

Flame retardants are compounds that reduce or prevent flame propagation or increase the inflammability of a material. Examples of flame retardants include but are not limited to halogenated aromatic compounds, like halogenated biphenyls or biphenyl ethers and bisphenols. Typically the halogenated materials are brominated or polybrominated. Specific examples include bisphenols like polybrominated biphenyl, penta-, octa and deca deca-brominated diphenyl ethers (BDE's), tetrabromobisphenol-A (TBBPA).
Further examples include but are not limited to inorganic compounds like alumina trihydrate, antimony oxide, magnesium hydroxide, zinc borate, organic and inorganic phosphates, red phosphor and combinations thereof.

### Anti-Dripping Agents:

Anti-dripping agents are substances that reduce or prevent dripping of a polymer when being exposed to a flame. Typically, dripping agents include fluoropolymers, such a polytetrafluoroethene polymers and copolymers. The dripping agents may be dispersed in or blended with the polymer making up the respective layer. Commercial examples of dripping agents include MM5935EF from Dyneon LLC, ALGOFLON DF210 from Solvay-Solexis or ENTROPY TN3500 from Shanghai Entropy Chemical.

### Pigments, dyes and reflective materials:

Pigments may be inorganic or organic. Pigments may be of green, blue, red, pink, purple and white colour. Pigments are dispersed in the layer containing them contrary to dyes which are dissolved in the layer containing them. Most commonly used white pigments are inorganic pigments. Examples include but are not limited to zink oxides and titanium oxides (like TiO₂). The pigments may be dispersed, blended or dissolved (in which case the pigments are more appropriately referred to as dyes) in the layer or may be painted or printed onto a layer. White pigments are typically used to enhance the reflective properties of the backsheet.

Reflective materials include glass particles or metal particles, with glass particles being preferred. They may be dispersed, blended or dissolved in a layer.

In one preferred embodiment of the present disclosure the backsheet is not transparent. Such backsheets are typically coloured. They may contain dyes or pigments or may be painted i.e. they contain a coloured coating. Preferably the non transparent backsheets contain white pigments as described above or they contain carbon particles.

### Carbon particles:

Carbon particles may be added to increase the weathering resistance of the backsheet. Carbon particles typically lead to the backsheet having a black colour. Examples of carbon particles include but are not limited to graphite, fullerenes, nanotubes, soot, carbon blacks (e.g. carbon black, acetylene black, ketjen black). The carbon particles may be modified, for example surface treated, coated or may contain functionalised groups (e.g. by chemical reaction with chemical modifiers or by adsorption of chemicals). The amount of carbon particles should be limited to values that do not render the backsheet electronically conductive. Typically, the layer may contain from about 1% to about 6% or up to about 10% weight based on the weight of the layer of carbon particles.

One or more scrim or net layers may also be present in the backsheet (13) for example attached to the polyolefin sheet (114) or incorporated into the polyolefin sheet (114) to further increase dimensional stability and handling properties. Scrim or net type layers may also improve the anti dripping performance during burning. Scrim or net layers are discontinuous layer of non-woven or woven polymeric material or organic or inorganic fibers. Scrim or net layers are typically net shaped to provide a discontinuous layer.

The backsheet (13) may contain patterns displaying information on its surface (rear and/or top surface). Such patterns may be symbols, numbers or letters or a plurality or combination thereof. Preferably the polyolefin-based sheet (114) contains such patterns because they can be easily provided on polyolefin-based materials. Patterns displaying information may be laminated onto the polyolefin-based sheets (114) or introduced into them by stamping. Such information may be, for example, a logo or instructions. The backsheets (13) provided herein are typically single-layer articles. Such articles are entirely made up by the polyolefin sheet (114) and the optional scrim material. The single layer backsheets (13) may contain polyolefin-sheets (114) that have been coated or painted and thus contain a coating or a film. Such coatings or films may be deposited onto the polyolefin sheet (114), for example by liquid film coating, spray coating, solvent coating, powder coating, sputtering and the like. However, single layer articles do not contain another continuous polymer sheet, (like for example an extruded polymer sheet) Such other continuous, and in particular extruded, polymer sheets typically have a thickness of greater than 50 µm or greater than 25 µm or greater than 15 µm. Thus, the term single layer article is meant to exclude the presence of other continuous layers polymer sheets other than the polyolefin sheet (114).

In one embodiment the polyolefin layer (114) contains the polyethene polymers described above and is free of polypropene polymers.

In another embodiment the polyolefin layer (114) contains the polypropene polymers described above and is free of polyethene polymers.

The backsheets (13) may have a thickness of at least 205 µm or at least 305 µm. Typically the backsheet may have a thickness of less than 950 µm. The Ibacksheet may contain, for example, up to about 10 wt %, preferably up to about 5 wt %, and more preferably up to about 1 wt % of anitoxidants based on the total weight of the backsheet. In addition or instead of antioxidants the layer may contain, for example, up to about 10 wt %, preferably up to about 5 wt %, and more preferably up to about 1 wt % of UV-stabilizers based on the total weight of the backsheet.
In addition or instead of antioxidants and/or UV-stabilizers the backsheet may contain anti-dripping agents like those described below. Typical amounts include up to 1% wt, or up to %wt or up to 10% wt based on the weight of the layer.
In addition to or instead of UV stabilizers, the backsheet may contain pigments selected from zink oxide and/or titanium dioxide. Typical amounts include up to 10% by weight.

It has been found that the polyolefin layers (114) provided herein may contain up to 35% or up to 30% by weight based on the weight of the layer of flame retardant and yet the backsheet has a dielectric break down voltage of at least 20 kV. Therefore, the polyolefin-based sheet (114) provided herein may contain up to 35 or up to 30% or up to 20% or up to 10% by weight based on the weight of the sheet of flame retardants.

### Methods of making backsheets:

The backsheets (13) according to the present disclosure can be produced by any suitable process. Single layer materials can be prepared by combining the ingredients and extruding the composition. The compositions can generally be extruded at a temperature of about 130°C to 250°C or 160 °C to about 280°C. The extruder contains a die adapted to the thickness and width of the resulting backsheet.

For co-extrusion the compositions making up the layer are prepared by mixing the ingredients. The compositions are then extruded in molten form through the respective sheet-shaping dies. After extrusion, the back sheets (13) are cross-linked as described above.

If desired, a surface of the encapsulant layer of the solar cell layer (12) facing the backing layer (13) and/or the top surface (131) of the backsheet (13) may be treated prior to the lamination process to incorporate the backsheet to enhance the adhesion of the backsheet to the solar cell layer. This adhesion enhancing treatment may take any form known within the art and may include flame treatments, plasma treatments, electron beam treatments, oxidation treatments, corona treatments, chemical treatments, chromic acid treatments, hot air treatments, ozone treatments, ultraviolet light treatments, sand blast treatments, solvent treatments, and combinations of two or more thereof.

The backsheets provided herein can be satisfyingly bonded to the encapsulant layer, in particular when the encapsulant layer contains EVA, or to the aluminium containing carrier material of the semiconductors or to an aluminium containing support structure by lamination, in particular vaccuum lamination. Lamination provides a bond between the substrates laminated together, i.e. a direct bond between the substrates contacting each other. Lamination typically involves a heat treatment. Lamination can be carried out at increased pressure but also under reduced pressure.

### Method of making solar modules:

Solar modules may be prepared by stacking the component layers of the solar cell module in a desired order to form a pre-lamination assembly. The assembly may then be subjected to lamination simultaneously or subsequently. Lamination may be carried out under vacuum or by the application of pressure.

For example the assembly may be placed into a bag capable of sustaining a vacuum ("a vacuum bag"), the air is drawn out of the bag by a vacuum line or other means, the bag is sealed while the vacuum is maintained and the sealed bag is placed in an autoclave at a pressure and temperature sufficient to provide lamination. A vacuum ring may be substituted for the vacuum bag. Following the heat and pressure cycle, the air in the autoclave may be cooled without introducing additional gas to maintain pressure in the autoclave. The excess air pressure is vented and the laminates are removed from the autoclave.

The pre-lamination assembly may also be heated in an oven after which the heated assembly may be passed through nip rolls so that the air in the void spaces between the individual layers may be squeezed out, and the edge of the assembly sealed. The assembly at this stage is referred to as a pre-press. The pre-press may then be placed in an air autoclave subjected to an appropriate temperature and pressure regime to achieve laminated products.

The backsheets (13) can be laminated to the solar cell layer (12) by standard lamination procedures. Preferably, the backsheets (13) are laminated to an encapsulated solar cell layer, preferably an encapsulant containing EVA.

The backsheets (13) may be laminated directly to the aluminium-containing surface of the carrier material in the solar cell layer or of a support structure by contacting aluminium-containing surface with the appropriate surface of the backsheet (13) and subjecting at least the backsheet to a heat treatment. Preferably increased or reduced pressure are applied. The heat treatment typically involves temperatures between 140 and 200°C. The backsheets may be subjected to a heat treatment, for example in an oven, and may be applied in hot form to the aluminium surface to which they are to bond. The hot backsheet is then pressed onto the surface to create a bond. Alternatively, the aluminium containing surface or both aluminium containing surface and backsheet may be subjected to the heat treatment for creating the bond.

Solar modules may be mounted on support structures by subjecting at least the back sheet to heat treatment, or alternatively or additionally also the support structure followed by contacting backsheet and surface for sufficient time and under sufficient pressure to form a bond.

The following list of exemplary embodiments illustrates various specific features, advantages, and other details of the invention. The particular materials and amounts recited in these exemplary embodiments, as well as other conditions and details, should not be construed in a manner that would limit the scope of this invention.

### List of embodiments:

1. A solar module (1) comprising in order of position from the front, i.e. the light-receiving side, to the back:
   (a) a top part (40) comprising a top layer (11) and a solar cell layer (12) and
   (b) a bottom part (41) comprising a backsheet (13) containing a polyolefin sheet (114) having a top surface (131) contacting at least partially the solar cell layer and opposite thereto a rear surface (111) that is at least partially exposed to the outside of the solar module (1) and which contains as its major component a cross-linked polymer selected from polyethene homo polymers, polypropene homopolymers, polyethene copolymers comprising repeating units derived from ethene and one or more α-olefinic hydrocarbons, polypropene copolymers comprising repeating units derived from propene and one or more α-olefinic hydrocarbons and combinations thereof.
2. The solar module according to 1.) wherein the polyolefin layer (114) comprises a cross-linked polyethene homo polymer or cross-linked polyethene copolymers comprising repeating units derived from ethene and one or more α-olefinic hydrocarbons,
3. The solar module according to 1.) or 2.) wherein the cross-linked polyethene homopolymer or copolymer has been cross-linked by e-beam treatment.
4. The solar module according to any one of 1.) to 3.) wherein the polyethene copolymer contains more than 80% by mole and more preferably at least 95% by mole or more than 99% by mole of units derived from ethene.
5. The solar module according to any one of the preceding embodiments wherein the polyethene polymer is selected from linear low densitiy polyethenes (LLDPE), low density polyethenes (LDPE), medium density polyethenes (MDPE), high density polyethenes (HDPE), or a combination thereof.
6. The solar module according to any one of the preceding embodiments wherein the polyethene polymer is selected from HDPE.
7. The solar module according to any one of the preceding embodiments wherein the backsheet (13) has a thickness of at least 0.250 mm.
8. The solar module according to any one of the preceding embodiments wherein the backsheet (13) has a thickness of from about 350 to about 650 µm.
9. The solar module according to any one of the preceding embodiments wherein the backsheet comprises UV stabilisers.
10. The solar module according to any one of the preceding embodiments wherein the backsheet (13) is not transparent.
11. The solar module according to any one of the preceding embodiments wherein the backsheet is not transparent and comprises white pigments.
12. The solar module according to any one of the preceding embodiments wherein the backsheet is not transparent and comprises carbon particles.
13. The solar module according to any one of the preceding embodiments wherein the backsheet (13) is dimensioned such that it can be wrapped around at least one or more than one edge of the top part (40) of the solar module.
14. The solar module according to any one of the preceding embodiments wherein the backsheet has a length greater than the length of the top part (40) of the solar module and the same width or a smaller width than the top layer of the solar module.
15. The solar module according to any one of the preceding embodiments wherein the backsheet has a length and a width that is greater than the length and the width of the top part (40) of the solar module and the same width or a smaller width than the top part (40) of the solar module.
16. The solar module according to any one of the preceding embodiments wherein the solar cell layer (12) contains semiconductors on an aluminium-containing carrier (124) and the backsheet (13) is directly bonded to the aluminium containing carrier.
17. The solar module according to any one of the preceding embodiments wherein the backsheet is a single layer article.
18. Method for making a solar module (1) comprising
   i) providing a top layer (10) and a solar cell layer (12) with semiconductors on an aluminium containing carrier (124), and a backsheet (13) as defined in any one of embodiments 1 to 16;
   ii) laminating the top surface (131) of the backsheet (13) to the rear surface of the aluminium containing carrier material (124).
19. The method according to embodiment 18 wherein the lamination involves subjecting at least the top surface (131) of the backing layer (13) or the carrier or both to a heat treatment.
20. Method for mounting a solar module (1) on an aluminium containing support structure comprising
   i) providing a solar module (1) according to any one of embodiments 1 to 17;
   ii) laminating the backsheet onto the support structure.
21. The method according to any one of embodiments 18 to 20 wherein the lamination involves a heat treatment by a temperature of greater than 140°C.
22. The method according to any one of embodiments 18 to 21 wherein the heat treatment is carried out at a temperature between 160°C and 200 °C.
23. An aluminum containing support structure for holding a solar module comprising a solar module (1) according to any one of embodiments 1 to 17 laminated by its backsheet to the support structure.
24. The support structure according to embodiment 23, selected from perimeter frames and backrails for solar modules.

### Examples:

### Materials:

| | |
|---|---|
| Hostavin N30 | sterically hindered amine light stabiliser (HALS), UV stabilizer, Clariant GmbH, Gersthofen, Germany, used as polyethene masterbatch containing 20% wt. of HALS in LUPOLEN 3020K). |
| Hostalen HD 9550 F | high density polyethylene (0,95 g/cm³) Lyondell Basell Industries Holdings B.V., Rotterdam, The Netherlands. |
| Lupolen 3020 K | low density polyethylene (0,927 g/cm³), Lyondell Basell Industries Holdings B.V., Rotterdam, The Netherlands. |
| Polybatch UV 1952 | stabilizer masterbatch, containing 10 % wt. of a hindered amine light stabilizer, A.Schulman GmbH, Kerpen, Germany. |
| Polywhite NG 8270 W | white masterbatch, containing 60% wt. titanium dioxide (rutile) in polyethylene, A.Schulman GmbH, Kerpen, Germany. |
| Polyblack 1423, | black masterbatch, containing 40% wt. carbon black in polyethylene, A.Schulman GmbH, Kerpen, Germany. |
| Polybatch PR 1049 DC | masterbatch containing flame retardants (halogenated organics), A. Schulman, Kerpen, Germany. |

### Methods:

### Dielectric breakdown voltage:

The dielectric breakdown voltage was determined according to ASTM D149, method A. The tests were carried on with type 2 electrodes and a voltage rate-of-rise of 500V/sec in a Hypotronics Type 970 dielectric breakdown strength tester. The tests were done in oil.

### Tensile strength:

The tensile strength and elongation at break were determined according to ASTM D-882 on a tensile tester, commercially available from Zwick, Germany with a 500 N load cell and a test speed of 100 mm/min.

### Pressure cooker test:

The samples were subjected to a pressure cooker test (DIN EN 60749-33) to test their endurance under wet heat conditions. The samples were placed on an aluminium tray in an oven. The aluminium tray was placed above the water reservoir (tap water) generating the steam. Test conditions were 121 °C at 1 bar pressure for 100 hours

Single layer polyethylene backsheets were prepared by blending the ingredients in a tumble mixer at room temperature, feeding the mixture into a single screw extruder and extruding the mixture through a die to give a 400 µm thick sheet. After extrusion the sheet was subjected to e-beam radiation to cross-link the material using an e-beam unit commercially available from Polymer Physics, using 295 kV with a beam current of 4 mA at a line speed of 3m/min and beam width of 30 cm. The samples were treated 4 times. A 50 cm x 20 cm wide sample was cut from the sheet for further testing.

### Example 1

A white backsheet was prepared as described above using a mixture of 75% wt of HOSTALEN HD 9950 F , 20% wt. POLYWHITE NG 8270 and 5% wt HOSTAVIN N30.

### Example 2

A black backsheet was prepared as described above using a mixture of 85% wt of HOSTALEN HD 9950 F , 10% wt. POLYBLACK 1423 and 5% wt HOSTAVIN N30.

The samples from examples 1 and 2 were tested for their electrical insulation (break down voltage) before and after the pressure cooker test and compared with a multilayer backsheet (fluoropolymer and polyester layers, 320 µm thickness, available as AKASOL PTL 3HR 1000 V from Krempe Ltd UK, comparative example). At the end of the pressure cooker test the samples were folded by 90°C over a sharp edge and folded back into their original position and then tested again for their electrical insulation. Table 1 shows the results obtained from three measurements.

**Table 1: properties before pressure cooker test**

| | Example 1 | Example 2 | Comparative Example |
|---|---|---|---|
| Initial breakdown voltage [kV] | 22.11 (+/- 0.70) | 20.54 (+/-0.38) | 20.64 (+/- 0.25) |
| Breakdown voltage [kV] after pressure cooker test and folding. [kV] | 22.64 (+/- 1.37) | 20.85 (+/- 1.37) | 5.11 (+/- 1.77) |

### Examples 3 and 4 (which are not claimed) demonstrate the adhesion of the cross-linked polyolefin sheets to aluminium surfaces. The tests measure the surface interaction of the external polyolefin layer with aluminium surfaces and the results therefore also apply to a single layer backing sheet of the same chemical composition.

### Example 3

A three layer polyethylene backsheet was prepared by first preparing the compositions for the individual layers. The top layer composition (layer (i)) was prepared by blending 2,000 g of Polywhite NG 8270 W with 7,500 g of Hostalen HD 9550 F and with 500 g of Polybatch UV 1952 in a tumble mixer at room temperature. The composition for the back layer (layer iii) was prepared by blending 1,000 g of Polyblack 1423 with 8,500 g Hostalen HD 9550 F and with 500 g of Polybatch UV 1952 in a tumble mixer at room temperature. The composition of the middle layer (layer (ii) was prepared by blending 9,500 g Lupolen 3020K with 500 g of Polybatch UV 1952 in a tumble mixer at room temperature.

To produce three-layered coextruded samples a coating line with 3 extruders was used. The white layer (i) was metered by a KTron Gravimetric Feeder, commercially available from KTron, Germany, into a twin screw extruder, commercially available from Werner & Pfleiderer, Germany, with a screw diameter of 25 mm and a length of 45 times the screw diameter. The middle layer was melted with a single screw extruder commercially available from Plastik Maschinenbau, Germany with a screw diameter of 45 mm and a length of 30 times the screw diameter. The black layer (iii) was melted with a single screw extruder commercially available from Extrudex, USA with a screw diameter of 30 mm and a length of 30 times the screw diameter. All 3 extruders fed the polymers into a Cloeren 3-layer-feed block to feed the molten stream into the positions i-ii-iii in the final melt stream. The melt stream was fed through a slot die, commercially available from EDI. The coextruded examples were made while casting from a slot die directly between a chilled stainless steel roll and a rubber roll without significant draw. The cooled layers were wound into a roll. After extrusion the three-layer product was subjected to e-beam radiation to cross-link the material using an e-beam unit commercially available from Polymer Physics, using 295 kV with a beam current of 4 mA at a line speed of 3m/min and beam width of 30 cm. The samples were treated 4 times. A 50 cm x 20 cm wide sample was cut from the sheet for further testing.

The polyolefin backsheets were subjected to a corona treatment (nitrogen atmosphere; energy density of 1J/cm²) and laminated in a vacuum laminator at 160°C and 9 minutes onto aluminum plates with a pressure of 1 bar. The peel force before weathering (pressure cooker test) was 18 N/cm as determined on a Zwick-Roell Z020 pull machine. An equivalent sample was tested in a pressure cooker test at 130°C and 2.8 bar water vapor pressure for 120 h. The peel force after weathering did not significantly change and was determined to be 17 N/cm. This test shows that the adhesion of the cross-linked polyolefin layer to the aluminium did not get reduced upon prolonged exposure to humid heat.

### Example 4:

A solar module prototype with a size of 10x15 cm (W x L) was prepared by vacuum lamination with the following set-up: 4mm glass, 2 layers of 0.48mm thick EVA and one layer of a polyethylene backsheet of example 3 (but not subjected to the corona treatment). The assembly was laminated at 160°C for 9 minutes (vaccum lamination, lamination pressure 1 bar). The polyethylene film was 1cm longer on each side than the glass. After the lamination the overhanging polyethene film was wrapped around the edge of the glass. An aluminum frame was preheated to 160°C on a hot plate. The aluminium frame had an opening for receiving the mini module of of 5mm. The minimodule was pressed by its wrapped edge into the opening of the heated frame. After cooling the mini module to room temperature the adhesion of the frame was so strong that that the mini module could not be pulled off from the frame by hand.

## Claims

1. A solar module (1) comprising in order of position from the front, i.e. the light-receiving side, to the back:
(a) a top part (40) comprising a top layer (11) and a solar cell layer (12) and
(b) a bottom part (41) comprising a backsheet (13) containing a polyolefin sheet (114) having a top surface (131) contacting at least partially the solar cell layer and opposite thereto a rear surface (111) that is at least partially exposed to the outside of the solar module (1) and which contains as its major component a cross-linked polymer selected from polyethene homo polymers, polypropene homopolymers, polyethene copolymers comprising repeating units derived from ethene and one or more α-olefinic hydrocarbons, polypropene copolymers comprising repeating units derived from propene and one or more α-olefinic hydrocarbons and combinations thereof.

2. The solar module according to claim 1 wherein the polyolefin sheet (114) comprises a cross-linked polyethene homo polymer or cross-linked polyethene copolymers comprising repeating units derived from ethene and one or more α-olefinic hydrocarbons,

3. The solar module according to claims 1 or 2 wherein the cross-linked polyethene homopolymer or copolymer has been cross-linked by e-beam treatment.

4. The solar module according to any one of the preceding claims wherein the polyethene copolymer contains more than 80% by mole and more preferably at least 95% by mole or more than 99% by mole of units derived from ethene.

5. The solar module according to any one of the preceding claims wherein the polyethene polymer is selected from linear low densitiy polyethenes (LLDPE), low density polyethenes (LDPE), medium density polyethenes (MDPE), high density polyethenes (HDPE), or a combination thereof.

6. The solar module according to any one of the preceding claims wherein the backsheet (13) has a thickness of at least 0.250 mm.

7. The solar module according to any one of the preceding claims wherein the backsheet comprises UV stabilisers.

8. The solar module according to any one of the preceding claims wherein the backsheet (13) is not transparent and comprises white pigments.

9. The solar module according to any one of claims 1-8 wherein backsheet (13) is dimensioned such that it can be wrapped around at least one or more than one edge of the top part (40) of the solar module.

10. The solar module according to any one of claims 1 to 9 wherein solar cell layer (12) contains an aluminium-containing carrier (124) and the backsheet (13) is directly bonded to the aluminium containing carrier.

11. Method for making a solar module (1) comprising
i) providing a top layer (11) and a solar cell layer (12) with semiconductors on an aluminium containing carrier (124), and a backsheet (13) as defined in any one of claims 1 to 10
ii) laminating the top surface (131) of the backsheet (13) to rear surface of the aluminium containing carrier material (124) by subjecting at least the top surface (131) of the backing layer (13) to a heat treatment.

12. Method for mounting a solar module (1) on an aluminium containing support structure comprising
i) providing a solar module (1) according to any one of claims 1 to 10;
ii) laminating the backsheet onto the support structure.

13. The method according to any one of claims 11 or 12 wherein the lamination involves heat treatment of a temperature of greater than 140 °C.

14. The method according to any one of claims 11 or 12 wherein the lamination involves a heat treatment of a temperature between 160°C and 200 °C.

15. An aluminium containing support structure (2) for holding a solar module comprising a solar module (1) according to any one of claims 1 to 10, laminated to at least a part of the support structure (2) by a direct bond between the backing layer (13) and support structure.
